# EUROPEAN PATENT APPLICATION

(11) **EP 4 838 770 A1**
(43) Date of publication of application: **11.11.2026**
(21) Application number: 26167616.7
(22) Date of filing: 25.03.2026
(51) Int. Cl.: H02M 1/00, H02M 3/156

(54) **CIRCUIT AND METHOD FOR ADJUSTING OUTPUT VOLTAGE OF DIRECT CURRENT/DIRECT CURRENT (DC/DC) VOLTAGE CONVERTER**

(30) Priority: 08.05.2025 CN 202510593294
(71) Applicant: Harman Becker Automotive Systems, Inc., Novi, MI 48377 (US)
(72) Inventor: SUN, Yiheng, Novi, MI, 48377 (US); CHEN, Haifeng, Novi, MI, 48377 (US)
(74) Representative: Westphal, Mussgnug & Partner, Patentanwälte mbB

(57) **Abstract**

The present disclosure provides a circuit for adjusting an output voltage of a Direct Current/Direct Current (DC/DC) voltage converter, including: a DC/DC voltage converter configured to receive an input voltage and provide an output voltage; a voltage feedback module configured to: generate a feedback voltage based on the output voltage, and provide the feedback voltage to a feedback pin of the DC/DC voltage converter, where the DC/DC voltage converter provides the output voltage based on the input voltage and the feedback voltage; a controller configured to: detect the input voltage of the DC/DC voltage converter, and generate a control signal and transmit the control signal to an adjustment module based on the input voltage being within a first voltage range; and the adjustment module configured to adjust the feedback voltage generated by the voltage feedback module based on the control signal, thereby adjusting the output voltage of the DC/DC voltage converter.

## Description

### Technical Field

The present disclosure relates to a circuit and method for adjusting an output voltage of a Direct Current/Direct Current (DC/DC) voltage converter.

### Background

In DC/DC voltage converter designs for electronic control units of automobiles, passenger cars and commercial cars typically use batteries that provide different input voltages. Because of the different input voltages, the electronic control units of different car models need to adopt different DC/DC voltage converter designs. To simplify the DC/DC voltage converter design, the design of a DC/DC voltage converter with a wide input voltage range may be considered for compatibility with input voltages of different ranges.

However, due to the operating characteristics of the DC/DC voltage converter, when the input voltage is lower than the set output voltage of the DC/DC voltage converter, the DC/DC voltage converter will not be able to operate in a switch mode, and a quiescent current will rise sharply. Therefore, there is a need for a circuit and method for adjusting the output voltage of the DC/DC voltage converter, enabling the DC/DC voltage converter to operate in the switch mode even if the input voltage of the DC/DC voltage converter is less than the set output voltage of the DC/DC voltage converter, and avoiding an excessive quiescent current.

### Summary of the Invention

Other aspects, advantages and significant features of the present disclosure will become apparent to those skilled in the art from the following detailed description disclosing various embodiments of the present disclosure in conjunction with the accompanying drawings.

According to an aspect of the present disclosure, a circuit for adjusting an output voltage of a Direct Current/Direct Current (DC/DC) voltage converter is provided, including: a DC/DC voltage converter configured to receive an input voltage and provide an output voltage; a voltage feedback module configured to: generate a feedback voltage based on the output voltage, and provide the feedback voltage to a feedback pin of the DC/DC voltage converter, where the DC/DC voltage converter provides the output voltage based on the input voltage and the feedback voltage; a controller configured to: detect the input voltage of the DC/DC voltage converter, and generate a control signal and transmit the control signal to an adjustment module based on the input voltage being within a first voltage range; and the adjustment module configured to adjust the feedback voltage generated by the voltage feedback module based on the control signal, thereby adjusting the output voltage of the DC/DC voltage converter.

According to another aspect of the present disclosure, a method for adjusting an output voltage of a Direct Current/Direct Current (DC/DC) voltage converter is provided, including: receiving an input voltage and providing an output voltage by a DC/DC voltage converter; generating a feedback voltage based on the input voltage and providing the feedback voltage to a feedback pin of the DC/DC voltage converter by a voltage feedback module, where the DC/DC voltage converter provides the output voltage based on the input voltage and the feedback voltage; detecting the input voltage of the DC/DC voltage converter by a controller and generating a control signal and transmitting the control signal to an adjustment module based on the input voltage being within a first voltage range; and adjusting the feedback voltage generated by the voltage feedback module based on the control signal by the adjustment module, thereby adjusting the output voltage of the DC/DC voltage converter.

### Brief Description of the Drawings

The present disclosure will be more readily understood from the following detailed description with reference to the accompanying drawings, in which like reference numerals refer to units of the same structure, and in which:
FIG. 1 illustrates a block diagram of a circuit for adjusting an output voltage of a DC/DC voltage converter according to an embodiment of the present disclosure;
FIG. 2 illustrates a detailed block diagram of a circuit for adjusting an output voltage of a DC/DC voltage converter according to an embodiment of the present disclosure;
FIG. 3 illustrates a schematic diagram of a circuit for adjusting an output voltage of a DC/DC voltage converter according to an embodiment of the present disclosure;
FIG. 4A illustrates a schematic diagram of an input voltage and an output voltage of a DC/DC voltage converter according to an embodiment of the present disclosure;
FIG. 4B illustrates a schematic diagram of a control signal generated by a controller according to an embodiment of the present disclosure;
FIG. 5 illustrates a flowchart of a method for adjusting an output voltage of a DC/DC voltage converter according to an embodiment of the present disclosure; and
FIG. 6 illustrates a schematic diagram of the application of a DC/DC voltage converter in the prior art.

Throughout the accompanying drawings, similar reference numerals will be understood as referring to similar parts, components and structures.

### Detailed Description of Embodiments

The technical solutions in the embodiments of the present disclosure will be clearly and completely described below in conjunction with the accompanying drawings in the embodiments of the present disclosure. Obviously, the described embodiments are merely some of the embodiments of the present disclosure, rather than all of the embodiments. Based on the embodiments of the present disclosure, all other embodiments derived by those of ordinary skills in the art without any creative efforts fall within the protection scope of the present disclosure.

Furthermore, those of ordinary skills in the art will understand that the elements in the accompanying drawings are illustrated for simplicity and may not necessarily be drawn to scale. For example, the dimensions of some elements in the accompanying drawings may be enlarged relative to other elements to aid in understanding various aspects of the embodiments. Furthermore, one or more elements may have been represented by various symbols in the accompanying drawings, and the accompanying drawings may illustrate only those specific details relevant to understanding the embodiments of the present disclosure, so as not to obscure the accompanying drawings with details that are readily apparent to those of ordinary skills in the art who benefit from the description herein.

In addition, it should be noted that in this specification, A being connected to B can mean "A is directly connected to B" or "A is connected to B via another intermediate member". A being connected between B and C can mean "A is directly connected to B and C" or "A is connected to B and C via another intermediate member".

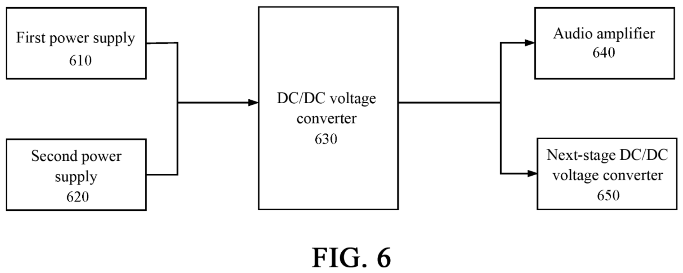

FIG. 6 illustrates a schematic diagram of the application of a DC/DC voltage converter in the prior art.

As shown in FIG. 6, the DC/DC voltage converter 630 may receive input voltages provided by a first power supply 610 and a second power supply 620, and provide output voltages to a load such as an audio amplifier 640 and a next-stage DC/DC voltage converter 650.

In some embodiments, the range of the input voltage provided by the first power supply 610 may be a first power supply voltage range, such as 8 V to 16 V, and the range of the input voltage provided by the second power supply 620 may be a second power supply voltage range, such as 18 V to 32 V. Therefore, the range of the input voltage of the DC/DC voltage converter 630 may be the union of the first power supply voltage range and the second power supply voltage range, e.g., 8 V to 32 V.

To satisfy a power requirement of the load such as the audio amplifier 640, a set output voltage of the DC/DC voltage converter 630 may be a specific voltage, such as 12 V.

In this case, when the input voltage of the DC/DC voltage converter 630 is greater than or equal to the set output voltage of the DC/DC voltage converter 630, for example, when the input voltage of the DC/DC voltage converter 630 is 20 V and the set output voltage of the DC/DC voltage converter 630 is 12 V, the DC/DC voltage converter 630 may operate in a switch mode, and a quiescent current is small when the DC/DC voltage converter 630 operates in the switch mode. However, when the input voltage of the DC/DC voltage converter 630 is less than the set output voltage of the DC/DC voltage converter 630, for example, when the input voltage of the DC/DC voltage converter 630 is 10 V and the set output voltage of the DC/DC voltage converter 630 is 12 V, the DC/DC voltage converter 630 will not be able to operate in the switch mode, and thus the quiescent current will increase sharply.

Therefore, the present disclosure proposes a circuit and method for adjusting the output voltage of the DC/DC voltage converter, ensuring that the DC/DC voltage converter can operate in the switch mode even if the input voltage of the DC/DC voltage converter is less than the set output voltage of the DC/DC voltage converter, and avoiding an excessive quiescent current.

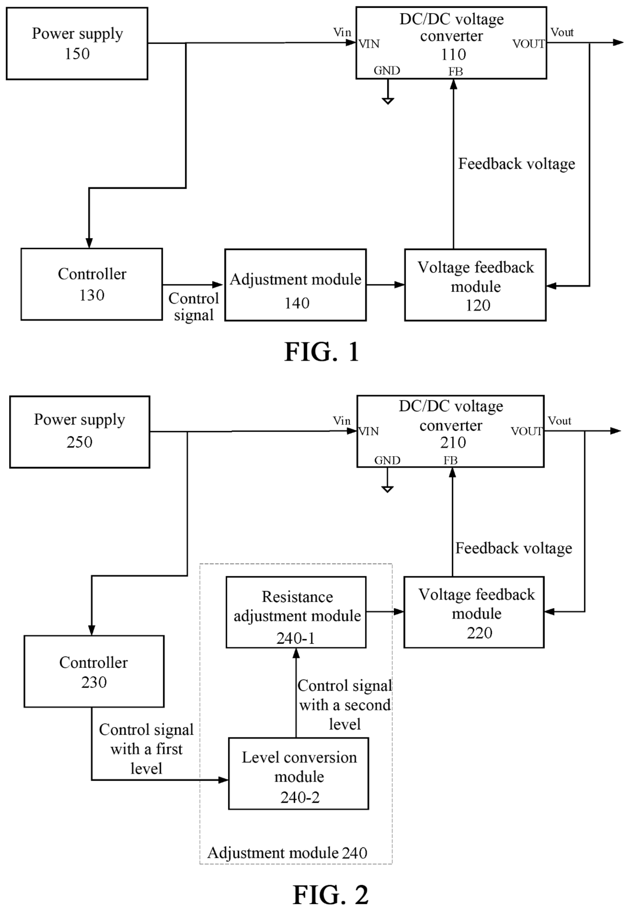

Next, the circuit and method for adjusting the output voltage of the DC/DC voltage converter according to the present disclosure will be described in detail with reference to FIG. 1 to FIG. 5.

FIG. 1 illustrates a block diagram of a circuit for adjusting an output voltage of a DC/DC voltage converter according to an embodiment of the present disclosure.

As shown in FIG. 1, the circuit for adjusting the output voltage of the DC/DC voltage converter may include a DC/DC voltage converter 110, a voltage feedback module 120, a controller 130 and an adjustment module 140. In some embodiments, the circuit for adjusting the output voltage of the DC/DC voltage converter may further include a power supply 150.

The DC/DC voltage converter 110 may include an input pin VIN, an output pin VOUT, a grounding pin GND and a feedback pin FB. However, the present disclosure is not limited thereto, and the DC/DC voltage converter 110 may include more pins.

The input pin VIN of the DC/DC voltage converter 110 may be connected to the power supply 150 to receive an input voltage Vin from the power supply 150. In some embodiments, the input voltage may be between 8 V and 32 V. The output pin VOUT of the DC/DC voltage converter 110 may be connected to a load or a next-stage DC/DC voltage converter to provide the output voltage Vout to the load or the next-stage DC/DC voltage converter. The feedback pin FB of the DC/DC voltage converter 110 may receive a feedback voltage provided by the voltage feedback module 120. The grounding pin GND of the DC/DC voltage converter 110 may be grounded.

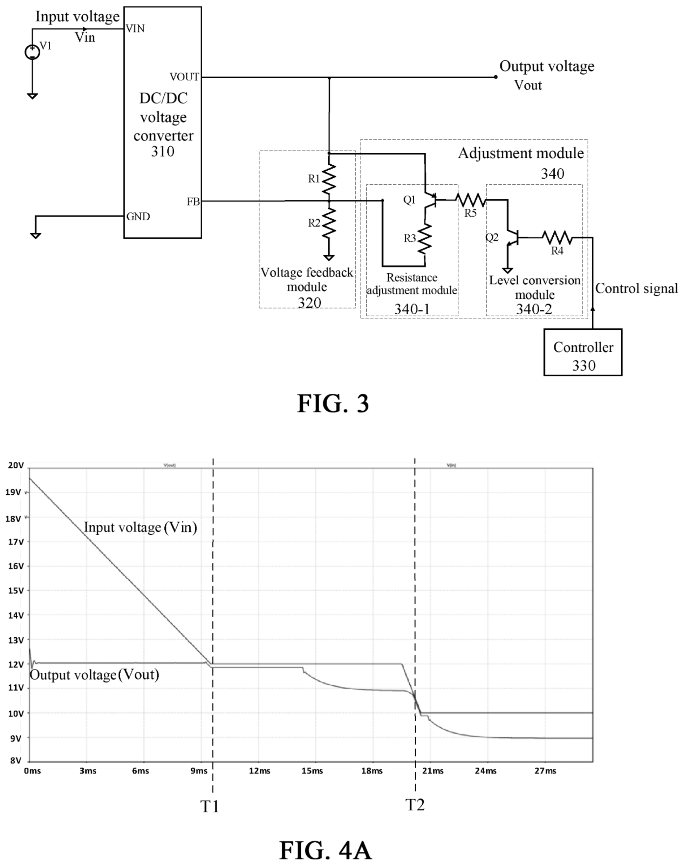

The voltage feedback module 120 may provide a feedback voltage to the DC/DC voltage converter 110. For example, the voltage feedback module 120 may detect the output voltage Vout of the DC/DC voltage converter 110, and provide the feedback voltage to the DC/DC voltage converter 110 based on voltage division between a plurality of resistors included in the voltage feedback module 120. The voltage feedback module 120 will be described in detail with reference to FIG. 3.

The controller 130 may detect the input voltage Vin of the DC/DC voltage converter 110 and generate a control signal. For example, when the input voltage Vin of the DC/DC voltage converter 110 is within a first voltage range, the controller 130 may generate the control signal and transmit the control signal to the adjustment module 140. For another example, when the input voltage Vin of the DC/DC voltage converter 110 is within a second voltage range, the controller 130 may not transmit the control signal to the adjustment module 140.

In some embodiments, the controller 130 may generate control signals with different levels based on the magnitude of the input voltage Vin of the DC/DC voltage converter 110. For example, when the input voltage Vin of the DC/DC voltage converter 110 decreases, the level of the control signal output by the controller 130 may increase.

In some embodiments, the upper limit of the first voltage range may be less than or equal to the lower limit of the second voltage range, and the first voltage range and the second voltage range may be related to the range of the input voltage Vin of the DC/DC voltage converter 110, the set output voltage of the DC/DC voltage converter 110, and a threshold voltage. For example, when the range of the input voltage Vin of the DC/DC voltage converter 110 is 8 V to 32 V, the set output voltage of the DC/DC voltage converter 110 is 12 V, and the threshold voltage is 1 V, the first voltage range may be 8 V to 13 V, and the second voltage range may be 13 V to 32 V. In other words, the first voltage range may be the lower limit of the input voltage Vin of the DC/DC voltage converter 110 to the set output voltage of the DC/DC voltage converter 110 plus the threshold voltage, and the first voltage range may be the set output voltage of the DC/DC voltage converter 110 plus the threshold voltage to the upper limit of the input voltage Vin of the DC/DC voltage converter 110. It should be understood that the present disclosure is not limited thereto. The range of the input voltage of and the set output voltage of the DC/DC voltage converter 110 may vary depending on the implementation, and different threshold voltages may be set, to obtain reasonable first voltage range and second voltage range, and to enable the DC/DC voltage converter 110 to operate in the switch mode even if the input voltage Vin of the DC/DC voltage converter 110 is within the first voltage range (i.e., the input voltage Vin of the voltage converter 110 is less than the output voltage Vout of the voltage converter 110).

The adjustment module 140 may adjust the feedback voltage generated by the voltage feedback module 120. Specifically, the adjustment module 140 may adjust the feedback voltage generated by the voltage feedback module 120 based on the control signal provided by the controller 130, thereby adjusting the output voltage of the DC/DC voltage converter 110. By adjusting the output voltage of the DC/DC voltage converter 110, a voltage difference between the output voltage and the input voltage may be made equal to the threshold voltage, thereby enabling the DC/DC voltage converter 310 to operate in the switch mode even if the input voltage Vin of the voltage converter 110 is less than the output voltage Vout of the voltage converter 110, and avoiding an excessive quiescent current. The voltage feedback module 120 will be described in detail with reference to FIG. 3.

FIG. 2 illustrates a detailed block diagram of a circuit for adjusting an output voltage of a DC/DC voltage converter according to an embodiment of the present disclosure.

As shown in FIG. 2, the circuit for adjusting the output voltage of the DC/DC voltage converter may include a DC/DC voltage converter 210, a voltage feedback module 220, a controller 230 and an adjustment module 240. The adjustment module 240 may include a resistance adjustment module 240-1 and a level conversion module 240-2. In some embodiments, the circuit for adjusting the output voltage of the DC/DC voltage converter may further include a power supply 250. The DC/DC voltage converter 210, the voltage feedback module 220, the controller 230 and the power supply 250 are similar to the DC/DC voltage converter 110, the voltage feedback module 120, the controller 130 and the power supply 150 described with reference to FIG. 1, and will not be described in detail here to avoid redundancy.

The level conversion module 240-2 may receive a control signal with a first level from the controller 230, and may convert the control signal with the first level into a control signal with a second level. In some embodiments, the first level is less than the second level. The level conversion module 240-2 may transmit the control signal with the second level to the resistance adjustment module 240-1.

The resistance adjustment module 240-1 may adjust the resistance of a voltage division resistor in the voltage feedback module 220 based on the control signal with the second level, thereby adjusting a feedback voltage provided by the voltage feedback module 220 to the DC/DC voltage converter 210 to adjust an output voltage Vout of the DC/DC voltage converter 210. The resistance adjustment module 240-1 and the level conversion module 240-2 will be described in detail with reference to FIG. 3

FIG. 3 illustrates a schematic diagram of a circuit for adjusting an output voltage of a DC/DC voltage converter according to an embodiment of the present disclosure.

As shown in FIG. 3, the circuit for adjusting the output voltage of the DC/DC voltage converter may include a DC/DC voltage converter 310, a voltage feedback module 320, a controller 330 and an adjustment module 340, where the adjustment module 340 may include a resistance adjustment module 340-1 and a level conversion module 340-2. In some embodiments, the circuit for adjusting the output voltage of the DC/DC voltage converter may further include a power supply V1. Although specific circuit examples of the voltage feedback module 320 and the adjustment module 340 are shown in FIG. 3, the present disclosure is not limited thereto.

The DC/DC voltage converter 310 may include an input pin VIN, an output pin VOUT, a feedback pin FB and a grounding pin GND. However, the present disclosure is not limited thereto, and the DC/DC voltage converter 310 may include more pins than shown in FIG. 3.

The input pin VIN of the DC/DC voltage converter 310 may be connected to the power supply V1 to receive an input voltage from the power supply V1. The output pin VOUT of the DC/DC voltage converter 310 may be connected to a load or a next-stage DC/DC voltage converter to provide the output voltage to the load or the next-stage DC/DC voltage converter. The feedback pin FB of the DC/DC voltage converter 310 may be connected to the voltage feedback module 320 to receive a feedback voltage. In addition, the grounding pin GND of the DC/DC voltage converter 310 may be grounded.

In some embodiments, the power supply V1 may provide an input voltage ranging from 8 V to 32 V to the DC/DC voltage converter 310. However, the present disclosure is not limited thereto, and the range of the input voltage that the power supply V1 can provide may vary depending on the implementation.

The voltage feedback module 320 may include a first resistor R1 and a second resistor R2. A first end of the first resistor R1 may be connected to the output pin VOUT of the DC/DC voltage converter 310, and a second end of the first resistor R1 may be connected to the feedback pin FB of the DC/DC voltage converter 310. A first end of the second resistor R2 may be connected to the feedback pin FB of DC/DC voltage converter 310, and a second end of the second resistor R2 may be grounded.

The first resistor R1 and the second resistor R2 can divide the output voltage of the DC/DC voltage converter 310, and a voltage across two ends of the second resistor R2 is provided as the feedback voltage to the feedback pin FB of the DC/DC voltage converter 310. In some embodiments, the magnitude of the resistance of an additional resistor connected in parallel between the two ends of the first resistor R1 may be changed by the resistance adjustment module 340-1, thereby adjusting voltage division between the first resistor R1 and the second resistor R2 to adjust the feedback voltage provided to the DC/DC voltage converter 310.

The controller 330 may detect the input voltage of the DC/DC voltage converter 310 and generate a control signal. For example, when the input voltage of the DC/DC voltage converter 310 is within a first voltage range, the controller 330 may generate the control signal and transmit the control signal to the level conversion module 340-2 of the adjustment module 340. For another example, when the input voltage of the DC/DC voltage converter 310 is within a second voltage range, the controller 330 may not transmit the control signal to the level conversion module 340-2 of the adjustment module 340.

In some embodiments, the upper limit of the first voltage range may be less than or equal to the lower limit of the second voltage range, and the first voltage range and the second voltage range may be related to the range of the input voltage of the DC/DC voltage converter 310, the set output voltage of the DC/DC voltage converter 310, and a threshold voltage. In some embodiments, the range of the input voltage of the DC/DC voltage converter 310 may be 8 V to 32 V, the set output voltage of the DC/DC voltage converter 310 may be 12 V, and the threshold voltage may be 1 V. Accordingly, the first voltage range may be 8 V to 13V, and the second voltage range may be 13 V to 32 V. However, the present disclosure is not limited thereto. The range of the input voltage of and the set output voltage of the DC/DC voltage converter 310 may vary depending on the implementation, and different threshold voltages may be set, to obtain reasonable first voltage range and second voltage range, and to enable the DC/DC voltage converter 310 to operate in the switch mode even if the input voltage of the DC/DC voltage converter 310 is within the first voltage range (i.e., the input voltage of the voltage converter 310 is less than the output voltage of the voltage converter 310).

In some embodiments, the controller 330 may generate a control signal with a first level based on detecting that the input voltage of the DC/DC voltage converter 310 is within the first voltage range, and transmit the control signal with the first level to the level conversion module 340-2. In some embodiments, the controller 330 may be implemented as a microcontroller unit (MCU). In some embodiments, the smaller the input voltage of the DC/DC voltage converter 310, the larger the value of the first level.

The level conversion module 340-2 may include a second transistor Q2, a fourth resistor R4 and an input end. An emitter electrode of the second transistor Q2 is grounded, a base electrode of the second transistor is connected to a first end of the fourth resistor, and a collector electrode of the second transistor is connected to the resistance adjustment module 340-1 via a fifth resistor R5. A second end of the fourth resistor is connected to the input end of the level conversion module to receive the control signal with the first level provided by the controller 330. The fifth resistor R5 is a specially set resistor or an equivalent resistor formed by a connection line between a base electrode of a first transistor Q1 and the collector electrode of the second transistor Q2.

When the controller 330 is implemented as an MCU, since an output voltage of the MCU is low, in order to enable the resistance adjustment module 340-1 to turn on a transistor (e.g., the first transistor Q1) included therein based on the control signal provided by the controller 330, voltage raise processing needs to be performed on the control signal provided by the controller 330. Specifically, the level conversion module 340-2 may convert the control signal with the first level that is received from the controller 330 into a control signal with a second level, and provide the control signal with the second level to the resistance adjustment module 340-1. In some embodiments, the first level is less than the second level.

The resistance adjustment module 340-1 may include the first transistor Q1 and a third resistor R3. An emitter electrode of the first transistor Q1 is connected to the first end of the first resistor R1 of the voltage feedback module 320, a collector electrode of the first transistor is connected to a first end of the third resistor R3 and a base electrode of the first transistor is connected to the level conversion module 340-2 via the fifth resistor R5. A second end of the third resistor R3 is connected to the second end of the first resistor R1. In some embodiments, the resistance adjustment module 340-1 may further include a capacitor C (not shown). A first end of the capacitor C may be connected to the emitter electrode of the first transistor Q1, and a second end of the capacitor C may be connected to the second end of the third resistor R3.

The resistance adjustment module 340-1 may turn on the first transistor Q1 based on the control signal with the second level that is received from the level conversion module 340-2, thereby providing the additional resistor connected in parallel between the two ends of the first resistor R1.

In some embodiments, when the controller 330 provides the control signal with the first level, the larger the value of the first level, the smaller the resistance of the additional resistor connected in parallel between the two ends of the first resistor R1, in which case a divisional voltage of the second resistor R2 is higher and the feedback voltage provided to the DC/DC voltage converter 310 is larger. The DC/DC voltage converter 310 may adjust the output voltage thereof based on the feedback voltage and a reference voltage, making a voltage difference between the output voltage and the input voltage equal to the threshold voltage, so as to enable the DC/DC voltage converter 310 to operate in the switch mode and avoid an excessive quiescent current.

FIG. 4A illustrates a schematic diagram of an input voltage and an output voltage of a DC/DC voltage converter according to an embodiment of the present disclosure.

In FIG. 4A, description is performed with the example in which the range of the input voltage of the DC/DC voltage converter is 8 V to 32 V, the set output voltage of the DC/DC voltage converter is 12 V, and the threshold voltage is 1 V. Accordingly, the first voltage range may be 8 V to 13V, and the second voltage range may be 13 V to 32 V. However, the present disclosure is not limited thereto. The range of the input voltage of and the set output voltage of the DC/DC voltage converter may vary depending on the implementation, and different threshold voltages may be set.

As shown in FIG. 4A, before a moment T1, when the input voltage Vin of the DC/DC voltage converter is within the second voltage range, the output voltage Vout of the DC/DC voltage converter may be kept at the set output voltage, such as 12 V. Specifically, when the input voltage Vin of the DC/DC voltage converter is within the first voltage range, the controller does not transmit the control signal to the adjustment module, thereby not adjusting the output voltage Vout of the DC/DC voltage converter.

Operations of the circuit are described with combined reference to FIG. 3. Before the moment T1, the output voltage Vout of the DC/DC voltage converter 310 is 12 V. In this case, the input voltage Vin of the DC/DC voltage converter 310 is greater than the output voltage Vout and is within the second voltage range. Therefore, the controller 330 does not provide the control signal (e.g., a control signal with an output level of 0) to the adjustment module 340. The emitter electrode of the first transistor Q1 is connected to the output pin VOUT of the DC/DC voltage converter, and neither the first transistor Q1 nor the second transistor Q2 is turned on. Accordingly, the adjustment module 340 does not adjust the feedback voltage provided to the DC/DC voltage converter 310, and therefore does not adjust the output voltage Vout of the DC/DC voltage converter 310.

Starting from the moment T1, the input voltage Vin of the DC/DC voltage converter starts to decrease and then enters the first voltage range. Moreover, based on the control signal provided by the controller, the output voltage Vout of the DC/DC voltage converter may be adjusted to a value that is less than the input voltage Vin by the threshold voltage, for example, a value that is less than the input voltage Vin by 1 V. In some cases, due to a delay of a loop response, there is a lag in adjusting the output voltage Vout of the DC/DC voltage converter based on the control signal. As shown in FIG. 4A, after the moment T1, rather than immediately starting to decrease, the output voltage Vout of the DC/DC voltage converter starts, after a period of time (e.g., a few milliseconds), to decrease to the value that is less than the input voltage Vin by the threshold voltage.

Specifically, when the input voltage Vin of the DC/DC voltage converter is within the first voltage range, the controller may transmit the control signal with the first level to the adjustment module. The level conversion module in the adjustment module may convert the control signal with the first level into the control signal with the second level, and provide the control signal with the second level to the resistance adjustment module. The resistance adjustment module may change the magnitude of the resistance of the additional resistor connected in parallel between the two ends of the first resistor in the voltage feedback module based on the received control signal with the second level, thereby changing the divisional voltage of the second resistor. The divisional voltage of the second resistor may be provided to the DC/DC voltage converter as a feedback voltage, and therefore, the DC/DC voltage converter may adjust the output voltage based on the changed feedback voltage and the reference voltage.

Operations of the circuit are described with combined reference to FIG. 3. Starting from the moment T1, the input voltage Vin of the DC/DC voltage converter 310 starts to decrease and then enters the first voltage range. Therefore, the controller 330 may provide a control signal of 330 mV to the adjustment module 340. The emitter electrode of the first transistor Q1 is connected to the output pin VOUT of the DC/DC voltage converter, and the second transistor Q2 and the first transistor Q1 may be turned on in sequence, thereby providing the additional resistor connected in parallel between the two ends of the first resistor. The magnitude of the resistance of the provided additional resistor connected in parallel between the two ends of the first resistor R1 may depend on an on-resistance of the first transistor Q1 and the third resistor R3. As the level of the control signal rises from 0 to 330 mV, the on-degree of the first transistor Q1 and the second transistor Q2 increases, and the on-resistance of the first transistor Q1 decreases, causing the resistance of the provided additional resistor connected in parallel between the two ends of the first resistor R1 to decrease, thereby increasing the voltage division proportion of the second resistor R2, i.e., increasing the feedback voltage provided to the DC/DC voltage converter 310.

Similarly, starting from a moment T2, the input voltage Vin of the DC/DC voltage converter 310 further decreases and is still within the first voltage range. Therefore, the controller 330 may provide a control signal of 360 mV to the adjustment module 340. As the level of the control signal rises from 330 mV to 360 mV, the on-degree of the first transistor Q1 and the second transistor Q2 further increases, and the on-resistance of the first transistor Q1 further decreases, causing the resistance of the provided additional resistor connected in parallel between the two ends of the first resistor R1 to further decrease, thereby further increasing the voltage division proportion of the second resistor R2, i.e., further increasing the feedback voltage provided to the DC/DC voltage converter 310.

Moreover, the level conversion module 340-2 in the adjustment module 340 may convert the control signal (the control signal with the first level) of the controller 330 into a signal with a higher level (the signal with the second level). When the controller 330 provides the control signal of 330 mV, the first level may be 330 mV, and the control signal with the second level may be obtained accordingly via the level conversion module 340-2. When the controller 330 provides the control signal of 360 mV, the first level may be 360 mV, and the control signal with the second level may be obtained accordingly via the level conversion module 340-2. The second level may be the output voltage Vout of the DC/DC voltage converter 310 minus a difference between an emitter electrode voltage and a base electrode voltage of the first transistor Q1. If the fifth resistor R5 is taken into consideration, the second level may be the output voltage Vout of the DC/DC voltage converter 310 minus the difference between the emitter electrode voltage and the base electrode voltage of the first transistor Q1 and minus a voltage across the fifth resistor R5.

In other words, when the output voltage Vout of the DC/DC voltage converter 310 is 12 V and the input voltage Vin of the DC/DC voltage converter 310 is within the second voltage range, the feedback voltage for the DC/DC voltage converter 310 may be of a specific value, such as 0.5 V. Moreover, when the input voltage Vin of the DC/DC voltage converter 310 decreases to be within the first voltage range, for example, it decreases to 12 V, the output voltage Vout of the DC/DC voltage converter 310 is caused to reach 11 V by adjusting the resistance of the additional resistor connected in parallel between the two ends of the first resistor R1, and in this case, the feedback voltage for the DC/DC voltage converter 310 is still of a specific value, such as 0.5 V. Similarly, when the input voltage Vin of the DC/DC voltage converter 310 further decreases and is still within the first voltage range, for example, it decreases to 11 V, the output voltage Vout of the DC/DC voltage converter 310 is caused to reach 10 V by adjusting the resistance of the additional resistor connected in parallel between the two ends of the first resistor R1, and in this case, the feedback voltage for the DC/DC voltage converter 310 is still of a specific value, such as 0.5 V.

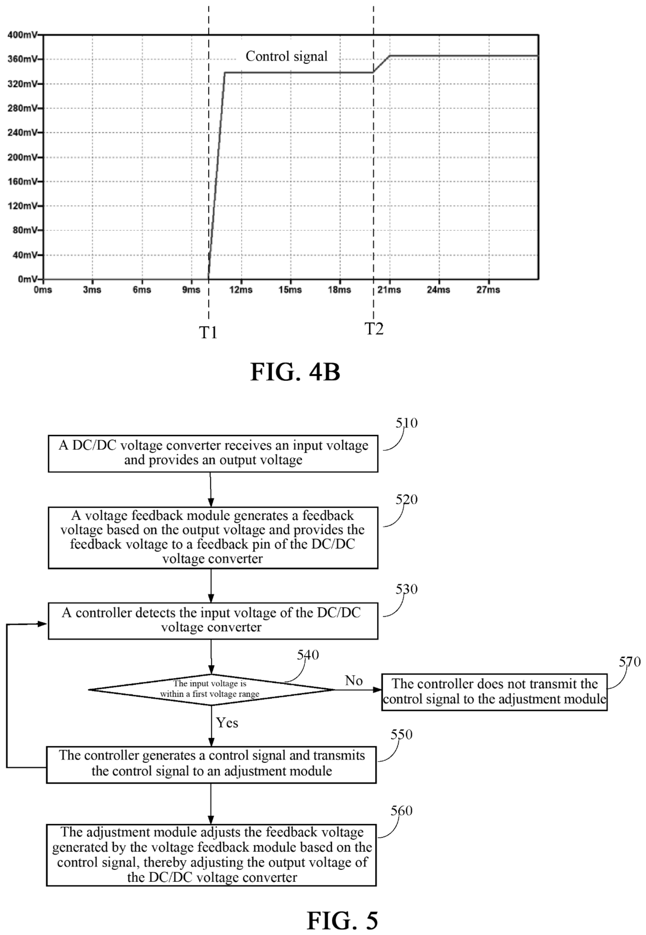

In this manner, the output voltage of the DC/DC voltage converter may be less than the input voltage of the DC/DC voltage converter by the threshold voltage, so as to control the output voltage of the DC/DC voltage converter, enabling the DC/DC voltage converter to operate in the switch mode, and thereby avoiding an excessive quiescent current. FIG. 4B illustrates a schematic diagram of a control signal generated by a controller according to an embodiment of the present disclosure.

With combined reference to FIG. 4A, as shown in FIG. 4B, before the moment T1, the input voltage Vin of the DC/DC voltage converter is within the second voltage range, and the controller does not generate a control signal.

At the moment T1, the input voltage Vin of the DC/DC voltage converter decreases and is within the second voltage range, and the controller may generate a control signal and may transmit the control signal to the adjustment module.

At the moment T2, the input voltage Vin of the DC/DC voltage converter further decreases but is still within the second voltage range, and the controller may generate a control signal with a level higher than the level of a control signal between the moment T1 and the moment T2 and may transmit the control signal to the adjustment module. It can be seen that when the input voltage Vin of the DC/DC voltage converter is within the second voltage range, the smaller the input voltage Vin of the DC/DC voltage converter is, the higher the level of the control signal generated by the controller may be, thereby making the resistance of the provided additional resistor connected in parallel between the two ends of the first resistor of the voltage feedback module smaller.

FIG. 5 illustrates a flowchart of a method for adjusting an output voltage of a DC/DC voltage converter according to an embodiment of the present disclosure.

At step S510, the DC/DC voltage converter may receive an input voltage and provide an output voltage. For example, the DC/DC voltage converter may receive an input voltage from a power supply and provide an output voltage. The DC/DC voltage converter may have a set output voltage value to satisfy the requirement of a load.

At step S520, a voltage feedback module may generate a feedback voltage based on the output voltage of the DC/DC voltage converter and provide the feedback voltage to a feedback pin of the DC/DC voltage converter. For example, the voltage feedback module may include a first resistor and a second resistor that are connected in series. The first resistor and the second resistor can divide the output voltage of the DC/DC voltage converter, and a voltage across two ends of the second resistor may be provided as the feedback voltage to the feedback pin of the DC/DC voltage converter. The DC/DC voltage converter may provide the output voltage based on the input voltage and the feedback voltage.

At step S530, a controller may detect the input voltage of the DC/DC voltage converter. In some embodiments, the controller may periodically detect the input voltage of the DC/DC voltage converter.

At step S540, the controller may determine whether the input voltage of the DC/DC voltage converter is within a first voltage range. The first voltage range may be associated with the range of the input voltage of the DC/DC voltage converter, a set output voltage of the DC/DC voltage converter and a threshold voltage.

Based on the input voltage of the DC/DC voltage converter being within the first voltage range, at step S550, the controller may generate a control signal and transmit the control signal to an adjustment module, causing the adjustment module to adjust the feedback voltage generated by the voltage feedback module. In some embodiments, when the input voltage of the DC/DC voltage converter is within the first voltage range, the lower the input voltage of the DC/DC voltage converter, the higher the level of the control signal generated by the controller.

Based on the input voltage of the DC/DC voltage converter being not within the first voltage range, at step S570, the controller may not transmit the control signal to the adjustment module, causing the adjustment module to not adjust the feedback voltage generated by the voltage feedback module.

At step S560, the adjustment module may adjust the feedback voltage generated by the voltage feedback module based on the control signal, thereby adjusting the output voltage of the DC/DC voltage converter. Specifically, the adjustment module may include a level conversion module and a resistance adjustment module. The level conversion module may convert a control signal with a first level into a control signal with a second level, and provide the control signal with the second level to the resistance adjustment module. The first level is less than the second level. The resistance adjustment module may turn on a triode included therein based on the received control signal with the second level, thereby providing an additional resistor connected in parallel between two ends of the first resistor. On that basis, a divisional voltage of the second resistor is changed, thereby changing the feedback voltage generated by the voltage feedback module. The DC/DC voltage converter may adjust the output voltage thereof based on the changed feedback voltage and a reference voltage.

It may be understood that the steps shown in FIG. 5 may not necessarily be executed in the order shown in the figure, and may be executed in parallel. Furthermore, the method for adjusting the output voltage of the DC/DC voltage converter may include more steps than shown in FIG. 5.

The technique of the present disclosure may include additional aspects, such as any single aspect or any combination of aspects described below and/or aspects related to one or more other processes described elsewhere herein.

Those of ordinary skills in the art may recognize that the units and algorithm steps of the various embodiments described in conjunction with the embodiments disclosed in the present disclosure can be implemented in electronic hardware, computer software or a combination thereof. In order to clearly illustrate the interchangeability of hardware and software, the composition and steps of the various embodiments have been generally described in terms of functionality in the foregoing description. Whether these functions are implemented in hardware or in software depends on the specific application of the technical solutions and design constraint conditions. Skilled professionals may use different methods to implement the described functions for each specific application, but such implementation should not be considered as going beyond the scope of the present disclosure.

Those skilled in the art may clearly understand that, for convenience and brevity of the description, the specific operation processes of the systems, apparatuses and units described above may be referred to the corresponding processes in the foregoing method embodiments, and will not be described in detail here.

In the embodiments provided in the present disclosure, it should be understood that the disclosed systems, apparatuses and methods can be implemented in other ways. For example, the apparatus embodiments described above are merely illustrative. For instance, the division of units is merely the division of logical functions. In actual implementations, there may be other division manners. For example, a plurality of units or assemblies may be combined or integrated into another system, or some features may be ignored or not executed. On the other hand, the mutual coupling or direct coupling or communicative connection shown or discussed may be indirect coupling or communicative connection via some interfaces, apparatuses or units, and may be electrical, mechanical or in other forms.

The units described as separate components may or may not be physically separate. The components shown as units may or may not be physical units, and may be located in one place or distributed onto a plurality of network units. Some or all of the units may be selected to achieve the purposes of the solutions of the embodiments according to actual needs.

In addition, various functional units in the various embodiments of the present disclosure may be integrated into one processing unit, or each unit may physically exist individually, or two or more units may be integrated into one unit. The integrated units described above may be implemented in the form of hardware or may be implemented in the form of software functional units.

The integrated units, when implemented in the form of software functional units and sold or used as independent products, can be stored in a computer-readable storage medium. Based on such the understanding, the technical solution of the present disclosure essentially is or the part thereof that contributes to the prior art or all or part of the technical solution can be embodied in the form of a software product. The computer software product is stored in a storage medium, including a number of instructions for enabling a computer device (which may be a personal computer, a server, a network device, etc.) to execute all or part of the steps of the method described in various embodiments of the present disclosure. The foregoing storage medium includes: a USB flash drive, a mobile hard drive, a read-only memory (ROM), a random access memory (RAM), a magnetic disk or an optical disk, and other media that can store program code.

The above descriptions are merely specific implementations of the present disclosure, and the protection scope of the present disclosure is not limited thereto. Changes or substitutions that can be easily conceived by those skilled in the art within the technical scope disclosed in the present disclosure should fall within the protection scope of the present disclosure. Therefore, the protection scope of the present disclosure should be determined by the protection scope of the claims.

## Claims

1. A circuit for adjusting an output voltage of a Direct Current/Direct Current (DC/DC) voltage converter, comprising:
a DC/DC voltage converter configured to receive an input voltage and provide an output voltage;
a voltage feedback module configured to:
generate a feedback voltage based on the output voltage; and
provide the feedback voltage to a feedback pin of the DC/DC voltage converter, wherein the DC/DC voltage converter provides the output voltage based on the input voltage and the feedback voltage;
a controller configured to:
detect the input voltage of the DC/DC voltage converter; and
generate a control signal and transmit the control signal to an adjustment module based on the input voltage being within a first voltage range; and
the adjustment module configured to adjust the feedback voltage generated by the voltage feedback module based on the control signal, thereby adjusting the output voltage of the DC/DC voltage converter.

2. The circuit of claim 1, wherein the controller is further configured to:
not transmit the control signal to the adjustment module based on the input voltage being within a second voltage range, such that the adjustment module does not adjust the feedback voltage generated by the voltage feedback module,
wherein in a case that the control signal is transmitted to the adjustment module based on the input voltage being within the first voltage range, the level of the control signal is associated with the input voltage of the DC/DC voltage converter.

3. The circuit of claim 1, wherein the adjustment module is further configured to:
increase the feedback voltage generated by the voltage feedback module based on receiving the control signal.

4. The circuit of claim 1, wherein a difference between the input voltage and the output voltage is greater than or equal to a threshold voltage.

5. The circuit of claim 1, wherein the voltage feedback module comprises:
a first resistor with a first end connected to an output pin of the DC/DC voltage converter and a second end connected to the feedback pin of the DC/DC voltage converter; and
a second resistor with a first end connected to the feedback pin of DC/DC voltage converter and a second end grounded.

6. The circuit of claim 5, wherein the adjustment module comprises a level conversion module and a resistance adjustment module, wherein
the level conversion module is configured to:
receive a control signal with a first level transmitted by the controller; and
convert the control signal with the first level into a control signal with a second level for controlling the resistance adjustment module; and
the resistance adjustment module is connected between the two ends of the first resistor and configured to:
provide an additional resistor connected in parallel between the two ends of the first resistor based on the control signal with the second level.

7. The circuit of claim 6, wherein the resistance adjustment module comprises a first transistor and a third resistor, and the level conversion module comprises a second transistor, a fourth resistor and an input end, and
wherein an emitter electrode of the first transistor is connected to the first end of the first resistor, a collector electrode of the first transistor is connected to a first end of the third resistor and a base electrode of the first transistor is connected to a collector electrode of the second transistor,
a second end of the third resistor is connected to the second end of the first resistor,
an emitter electrode of the second transistor is grounded and a base electrode of the second transistor is connected to a first end of the fourth resistor, and
a second end of the fourth resistor is connected to the input end of the level conversion module to receive the control signal with the first level.

8. The circuit of claim 7, wherein the adjustment module is further configured to:
turn on the second transistor and the first transistor in sequence based on receiving the control signal with the first level, such that the additional resistor connected in parallel between the two ends of the first resistor is generated, wherein the larger the value of the first level, the smaller the resistance of the additional resistor connected in parallel.

9. A method for adjusting an output voltage of a Direct Current/Direct Current (DC/DC) voltage converter, comprising:
receiving an input voltage and providing an output voltage by a DC/DC voltage converter;
generating a feedback voltage based on the input voltage and providing the feedback voltage to a feedback pin of the DC/DC voltage converter by a voltage feedback module, wherein the DC/DC voltage converter provides the output voltage based on the input voltage and the feedback voltage;
detecting the input voltage of the DC/DC voltage converter by a controller and generating a control signal and transmitting the control signal to an adjustment module based on the input voltage being within a first voltage range; and
adjusting the feedback voltage generated by the voltage feedback module based on the control signal by the adjustment module, thereby adjusting the output voltage of the DC/DC voltage converter.

10. The method of claim 9, further comprising:
not transmitting the control signal to the adjustment module by the controller based on the input voltage being within a second voltage range, such that the adjustment module does not adjust the feedback voltage generated by the voltage feedback module,
wherein in a case that the control signal is transmitted to the adjustment module based on the input voltage being within the first voltage range, the level of the control signal is associated with the input voltage of the DC/DC voltage converter.

11. The method of claim 9, further comprising:
increasing the feedback voltage generated by the voltage feedback module by the adjustment module based on receiving the control signal.

12. The method of claim 9, wherein the voltage feedback module comprises:
a first resistor with a first end connected to an output pin of the DC/DC voltage converter and a second end connected to the feedback pin of the DC/DC voltage converter; and
a second resistor with a first end connected to the feedback pin of DC/DC voltage converter and a second end grounded.

13. The method of claim 12, wherein the adjustment module comprises a level conversion module and a resistance adjustment module, and the method further comprises:
receiving a control signal with a first level transmitted by the controller by the level conversion module, and converting the control signal with the first level into a control signal with a second level for controlling the resistance adjustment module; and
providing an additional resistor connected in parallel between the two ends of the first resistor by the resistance adjustment module based on the control signal with the second level, wherein the resistance adjustment module is connected between the two ends of the first resistor.

14. The method of claim 13, wherein
the resistance adjustment module comprises a first transistor and a third resistor, and the level conversion module comprises a second transistor, a fourth resistor and an input end, and
wherein an emitter electrode of the first transistor is connected to the first end of the first resistor, a collector electrode of the first transistor is connected to a first end of the third resistor and a base electrode of the first transistor is connected to a collector electrode of the second transistor,
a second end of the third resistor is connected to the second end of the first resistor,
an emitter electrode of the second transistor is grounded and a base electrode of the second transistor is connected to a first end of the fourth resistor, and
a second end of the fourth resistor is connected to the input end of the level conversion module to receive the control signal with the first level.

15. The method of claim 14, further comprising:
turning on the second transistor and the first transistor in sequence by the adjustment module based on receiving the control signal with the first level, such that the additional resistor connected in parallel between the two ends of the first resistor is generated, wherein the larger the value of the first level, the smaller the resistance of the additional resistor connected in parallel.
